(19) **Europäisches Patentamt**
**European Patent Office**
**Office européen des brevets**

(11) **EP 4 764 543 A1**

(12) **EUROPEAN PATENT APPLICATION**
published in accordance with Art. 153(4) EPC

(43) Date of publication:
**24.06.2026 Bulletin 2026/26**

(21) Application number: **25755068.1**

(22) Date of filing: **15.01.2025**

(51) International Patent Classification (IPC):
*G01R 31/392* (2019.01)   *G01R 31/367* (2019.01)
*G01R 31/382* (2019.01)   *G01R 31/36* (2020.01)
*G01R 31/396* (2019.01)   *G06F 17/18* (2006.01)

(52) Cooperative Patent Classification (CPC):
**G01R 31/36; G01R 31/367; G01R 31/382;**
**G01R 31/392; G01R 31/396; G06F 17/18;**
**Y02E 60/10**

(86) International application number:
**PCT/KR2025/000860**

(87) International publication number:
**WO 2025/173946 (21.08.2025 Gazette 2025/34)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **15.02.2024 KR 20240021602**

(71) Applicant: **LG Energy Solution, Ltd.**
**Seoul 07335 (KR)**

(72) Inventors:
• **KIM, Seung Hyun**
  **Daejeon 34122 (KR)**
• **CHUNG, Mi Kyung**
  **Daejeon 34122 (KR)**
• **KOH, Dong Wook**
  **Daejeon 34122 (KR)**

(74) Representative: **Plasseraud IP**
**104 Rue de Richelieu**
**CS92104**
**75080 Paris Cedex 02 (FR)**

(54) **BATTERY DIAGNOSTIC DEVICE AND OPERATING METHOD THEREOF**

(57)    A battery diagnostic device according to an embodiment disclosed herein includes a data acquisition unit configured to acquire voltage data and current data of a battery, a state of charge (SOC) calculation unit configured to calculate an SOC of the battery based on the current data, an error calculation unit configured to calculate an SOC error of the battery based on the calculated SOC of the battery and a reference SOC of the battery, and a state of health (SOH) prediction unit configured to calculate an SOH of the battery based on the SOC and the SOC error of the battery, input the calculated SOH of the battery into a linear regression model to derive a linear regression equation of the SOH of the battery, and predict the SOH of the battery based on the linear regression equation.

FIG.1

**Description**

## CROSS-REFERENCE TO RELATED APPLICATION

The present application claims the benefit of the priority of Korean Patent Application No. 10-2024-0021602, filed on February 15, 2024, which is hereby incorporated by reference in its entirety.

## TECHNICAL FIELD

An embodiment disclosed herein relates to a battery diagnostic device and a method of operating the same.

## BACKGROUND ART

In recent years, research and development for secondary batteries have been actively conducted. Here, the secondary battery is a battery capable of recharging and discharging, and in its meaning, includes all of the existing Ni/Cd battery, Ni/MH battery, and the like and a recent lithium-ion battery. Among secondary batteries, the lithium-ion battery has the advantage of a much higher energy density than the existing Ni/Cd battery, Ni/MH battery, and the like. In addition, since the lithium-ion battery may be manufactured to be small and lightweight, the lithium-ion battery is used as a power source for mobile devices, and in recent years, its scope of use has expanded to include power sources for electric vehicles, so that the lithium-ion battery attracts attention as a next-generation energy storage medium.

Since secondary batteries deteriorate with repeated use, in order to efficiently manage secondary batteries, there is a need to continuously monitor the state of charge (SOC) and state of health (SOH), which indicate the degree of deterioration of the secondary batteries. However, since parameters such as the SOC and SOH, which indicate the degree of deterioration of secondary batteries, are indicators estimated based on the voltage and current of the secondary batteries, there is a need to improve the reliability of the parameters.

## DISCLOSURE OF THE INVENTION

## TECHNICAL PROBLEM

The embodiments disclosed herein are directed to providing a battery diagnostic device and a method of operating the same for predicting the state of health (SOH) of a battery more accurately.

The technical problems of the embodiments disclosed herein are not limited to the technical problems mentioned above, and other technical problems not mentioned will be clearly understood by those skilled in the art to which the present invention belongs from the description below.

## TECHNICAL SOLUTION

According to an embodiment of the present invention, a battery diagnostic device includes a data acquisition unit configured to acquire voltage data and current data of a battery; a state of charge (SOC) calculation unit configured to calculate an SOC of the battery based on the current data; an error calculation unit configured to calculate an SOC error of the battery based on the calculated SOC of the battery and a reference SOC of the battery; and a state of health (SOH) prediction unit configured to calculate an SOH of the battery based on the SOC and the SOC error of the battery, input the calculated SOH of the battery into a linear regression model to derive a linear regression equation of the SOH of the battery, and predict the SOH of the battery based on the linear regression equation.

According to an embodiment, the SOC calculation unit may calculate the SOC of the battery based on a current integration method that integrates the current data, and the current integration method may be performed based on the following Equation 1.

[Equation 1]

$$SOC = \frac{\int i \, dt}{Capacity_{BoL}}$$

(the $Capacity_{BoL}$ corresponds to an initial capacity of the battery)

According to an embodiment, the error calculation unit may calculate the SOC error by calculating a difference between the SOC of the battery and a reference SOC that is an SOC obtained by converting a reference voltage based on a reference OCV-SOC table.

According to an embodiment, the reference voltage may include data related to a voltage of a battery maintained in an idle state for a preset threshold time section from a point in time at which a charging and discharging operation of the battery is ended.

According to an embodiment, the error calculation unit may predict the reference voltage based on the voltage data when a length of a time section between the point in time at which the charging and discharging operation of the battery is ended and a point in time at which the voltage data is acquired is shorter than a length of the threshold time section.

According to an embodiment, the error calculation unit may identify an inflection point of a voltage graph over time, from the point in time at which the charging and discharging operation of the battery is ended, that is included in the voltage data, and perform exponential function linear modeling based on the identified inflection point to generate a voltage graph up to the length of the threshold time section.

According to an embodiment, the error calculation unit may predict a voltage after the threshold time section elapses from the point in time at which the charging and discharging operation is ended as the reference voltage based on the generated voltage graph.

According to an embodiment, the SOH prediction unit may calculate the SOH of the battery based on the following Equation 2.

[Equation 2]

$$SOH = 100 - \frac{SOC_{error}}{SOC - SOC_{error}} * 100$$

(here, $SOC_{error}$ corresponds to the SOC error)

According to an embodiment, the linear regression model may include a weighted linear regression model that assigns a different weight to an independent variable, and the independent variable may correspond to the calculated SOH of the battery.

According to an embodiment, the SOH prediction unit may derive the linear regression equation by assigning a different weight to the calculated SOH based on the SOC value, wherein a value of the weight increases as the SOC value increases.

According to an embodiment of the present invention, a method of operating a battery diagnostic device includes acquiring voltage data and current data of a battery; calculating an SOC of the battery based on the current data; calculating an SOC error of the battery based on the calculated SOC of the battery and a reference SOC of the battery; and calculating an SOH of the battery based on the SOC and the SOC error of the battery, inputting the calculated SOH of the battery into a linear regression model to derive a linear regression equation of the SOH of the battery and predicting the SOH of the battery based on the linear regression equation.

According to an embodiment, the calculating of the SOC of the battery may include calculating the SOC of the battery based on a current integration method that integrates the current data, and the current integration method is performed based on the following Equation 1.

[Equation 1]

$$SOC = \frac{\int i\,dt}{Capacity_{BoL}}$$

(the $Capacity_{BoL}$ corresponds to an initial capacity of the battery)

According to an embodiment, the calculating of the SOC error may include acquiring a reference SOC corresponding to a reference voltage based on a reference OCV-SOC table; and calculating a difference between the calculated SOC and the reference SOC.

According to an embodiment, the reference voltage may include data related to a voltage of a battery maintained in an idle state for a preset threshold time section from a point in time at which a charging and discharging operation of the battery is ended.

According to an embodiment, the acquiring of the reference SOC corresponding to the reference voltage may include identifying a length of a time section between a point in time at which the charging and discharging operation of the battery is ended and a point in time at which the voltage data is acquired; identifying an inflection point of a voltage graph over time, from a point in time at which the charging and discharging operation of the battery is ended, that is included in the voltage data when the length of the time section is shorter than a length of a preset threshold time section; and performing exponential function linear modeling based on the identified inflection point to generate a voltage graph up to the length of the threshold time section.

According to an embodiment, the predicting of the SOH of the battery may be performed based on the following Equation 2.

$$[\text{Equation 2}]$$

$$SOH = 100 - \frac{SOC_{error}}{SOC\text{-}SOC_{error}} * 100$$

(here, $SOC_{error}$ corresponds to the SOC error, and $Capacity_{BoL}$ corresponds to an initial capacity of the battery)

According to an embodiment, the linear regression model may include a weighted linear regression model that assigns a different weight to an independent variable, and the independent variable may correspond to the calculated SOH of the battery.

**ADVANTAGEOUS EFFECTS**

According to an embodiment disclosed herein, the SOH of a battery can be predicted more accurately.

The effects according to the embodiment disclosed herein are not limited to those mentioned above, and other effects not mentioned will be clearly understood by those skilled in the art from the disclosure herein.

**BRIEF DESCRIPTION OF THE DRAWINGS**

FIG. 1 is a diagram for describing a battery diagnostic device according to an embodiment disclosed herein.

FIG. 2 is a graph for describing an SOC error according to an embodiment disclosed herein.

FIG. 3 is a view for describing a process of calculating a reference voltage according to an embodiment disclosed herein.

FIG. 4 is a view for describing a weight assigned according to an embodiment disclosed herein.

FIG. 5 is a view for describing a linear regression equation according to an embodiment disclosed herein.

FIG. 6 is a view for describing the operation of a battery diagnostic device according to an embodiment disclosed herein.

FIG. 7 is a view for describing the operation of the battery diagnostic device according to an embodiment disclosed herein.

FIG. 8 is a diagram for describing a computing system according to an embodiment disclosed herein.

**MODE FOR CARRYING OUT THE INVENTION**

Hereinafter, embodiments disclosed herein will be described in detail with reference to exemplary drawings. In adding reference numerals to the components of each drawing, it should be noted that the same components are given the same reference numerals as much as possible even though they are shown on different drawings. In addition, in describing the embodiments disclosed herein, when a detailed description of a related known configuration or function is determined to hinder understanding of the embodiments disclosed herein, the detailed description thereof is omitted.

In addition, in describing a component of the embodiments disclosed herein, terms such as first, second, A, B, (a), (b), etc. may be used. These terms are only for distinguishing the component from other components, and the essence, sequence, or order of the component is not limited by the terms. In addition, unless otherwise defined, all terms used herein, including technical or scientific terms, have the same meaning as commonly understood by those of ordinary skill in the art to which the embodiments disclosed herein belong. Terms, such as those defined in commonly used dictionaries, should be interpreted as having a meaning that is consistent with their meaning in the context of the related art and will not be interpreted in an idealized or overly formal sense unless expressly so defined herein.

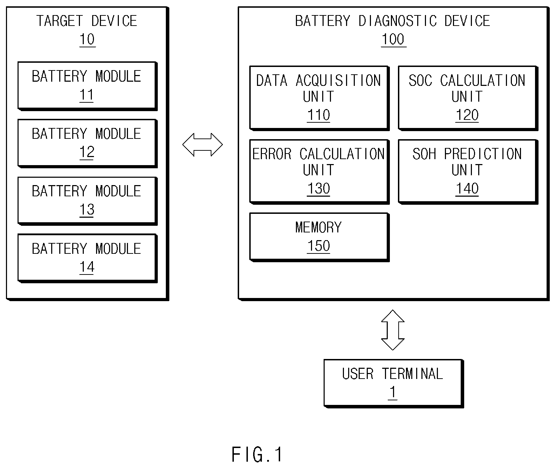

FIG. 1 is a diagram for describing a battery diagnostic device 100 according to an embodiment disclosed herein.

A target device 10 may include a plurality of battery modules 11, 12, 13, and 14. In FIG. 1, the target device 10 is illustrated as including four battery modules, but is not limited to this example, and the target device 10 may be configured to include n (n is a natural number equal to or greater than 2) battery modules. In addition, each of the plurality of battery modules 11, 12, and 13 may include a plurality of battery cells (not illustrated). Here, the plurality of battery modules 11, 12, 13, and 14 may constitute one or more battery packs, and the battery pack may be configured to supply electrical power to the target device 10.

In addition, a plurality of battery cells (not illustrated) are basic units of a battery that may be used by charging and discharging electric energy, and may be a lithium-ion (Li-ion) battery, a lithium-ion polymer (Li-ion polymer) battery, a nickel-cadmium (Ni-Cd) battery, a nickel-metal hydride (Ni-MH) battery, or the like, but are not limited thereto.

The target device 10 may operate by receiving power from the battery modules 11, 12, 13, and 14 and/or a battery pack (not illustrating) including at least one battery module 11, 12, 13, or 14. Here, the target device 10 may include an electrical, electronic or mechanical device that operates by receiving power from the battery modules 11, 12, 13, and 14 and/or the battery pack (not illustrated) including at least one battery module 11, 12, 13, or 14, and for example, the target device 10 may be an electric vehicle (EV), a mobile device (e.g., a mobile phone, a laptop computer, a smartphone, or the like), an energy storage system (ESS), a battery swapping station (BSS), or the like, but is not limited to these examples.

The battery diagnostic device 100 may be configured to predict a state of health (SOH) of the battery pack 10.

Referring to FIG. 1, the battery diagnostic device 100 may include a data acquisition unit 110, an SOC calculation unit 120, an error calculation unit 130, an SOH prediction unit 140, and a memory 150.

The battery diagnostic device 100 may be configured to be connected to the target device 10 to diagnose the battery pack (not illustrated) included in the target device 10, at least one of the battery modules 11, 12, 13, and 14 included in the battery pack (not illustrated), and/or the like. To this end, the battery diagnostic device 100 may be connected to the target device 10 via a wired network, a wireless network, and/or the like, and to this end, the battery diagnostic device 100 may include a communication module or the like that is not illustrated in FIG. 1.

According to an embodiment, the battery diagnostic device 100 may be connected to the target device 10 via a wired network such as a local area network (LAN) communication, a power line communication, or the like, and/or a wireless network such as a Bluetooth connection, a Wireless Fidelity (WIFI), an Infrared Data Association (IrDA), a cellular network, a 4G, a 5G network connection, or the like, but is not limited to these examples.

According to an embodiment, the battery diagnostic device 100 may be connected to the target device 10 through an inter-device communication interface. For example, the battery diagnostic device 100 may be connected through a communication interface such as a bus, general purpose input and output (GPIO), serial peripheral interface (SPI), mobile industry processor interface (MIPI), or the like, but is not limited thereto.

The battery diagnostic device 100 may directly and/or indirectly acquire voltage data related to voltage, current data related to current, and temperature data related to temperature of each of a battery pack (not illustrated) included in the target device 10, at least one of the battery modules 11, 12, 13, and 14 included in the battery pack (not illustrated), and battery cells (not illustrated) included therein. For example, when the battery diagnostic device 100 is implemented in the form of a battery management system (BMS) that manages and controls a battery pack (not illustrated) and/or at least one of the battery modules 11, 12, 13, and 14 included in the battery pack (not illustrated), or is mounted on the battery management system, the battery diagnostic device 100 may directly measure the voltage, current, and temperature of each of the battery pack (not illustrated) and/or the battery modules 11, 12, 13, and 14. In such cases, various sensors (not illustrated) not illustrated in FIG. 1 may be additionally positioned.

According to another embodiment, the battery diagnostic device 100 may indirectly acquire voltage data related to voltage, current data related to current, and temperature data related to temperature of each of the battery pack (not illustrated) and/or battery modules 11, 12, 13, and 14 and battery cells (not illustrated) included in the target device 10. That is, when the battery diagnostic device 100 is implemented as a separate device from the battery management system (not illustrated) described above, the battery diagnostic device 100 may acquire voltage data, current data, temperature data, and the like, provided by the battery management system (not illustrated) included in the target device 10 to a cloud server (not illustrated) or the like. In the following, the battery diagnostic device 100 is described as being a separate device from the battery management system, but is not limited to this example.

The data acquisition unit 110 may acquire the voltage data, current data, temperature data, and the like, of the battery. Here, the battery may be a unit corresponding to any one of the battery packs (not illustrated), battery modules 11, 12, 13, and 14 described above, and battery cells included therein. According to an embodiment, the data acquisition unit 110 may acquire data provided by the battery management system (not illustrated) included in the target device 10 to the cloud server or the like. Here, the voltage data and current data may include graphs or the like related to changes in the voltage and current of the battery over time, but are not limited thereto.

The SOC calculation unit 120 may calculate a state of charge (SOC) of the battery based on the current data acquired by the data acquisition unit 110. According to an embodiment, the SOC calculation unit 120 may calculate the SOC of the battery through a current integration method. Here, the current integration method may be a method of calculating the amount of charge by integrating the current during a charge/discharge cycle of the battery to an initial SOC value of the battery.

According to an embodiment, the SOC calculation unit 120 may calculate the SOC of the battery based on the

following Equation 1.

[Equation 1]

$$SOC = \frac{\int i\, dt}{Capacity_{BoL}}$$

(here, SOC corresponds to the SOC of the battery calculated through the current integration method based on current data, and $Capacity_{BoL}$ corresponds to the initial capacity of the battery)

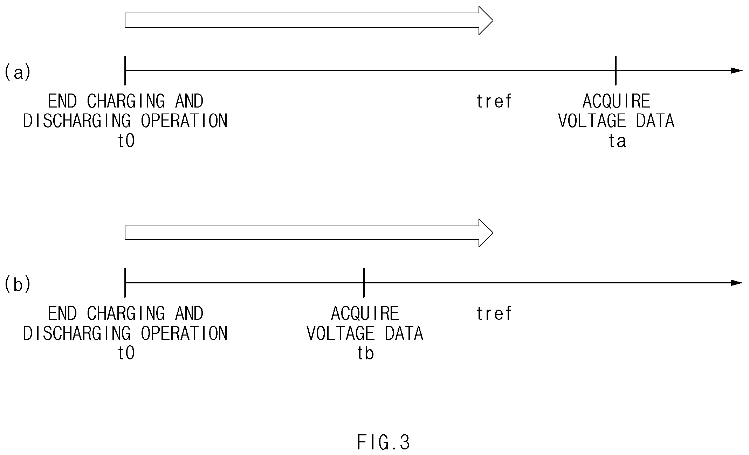

The error calculation unit 130 may calculate an SOC error of the battery based on the calculated SOC of the battery and a reference SOC. Here, the reference SOC may be an SOC corresponding to a reference voltage, which is the voltage of the battery at a point in time at which a preset threshold time section elapses from a point in time at which the charging and discharging operation of the battery is completed. Details regarding the reference voltage are described below in the description of FIG. 3.

According to an embodiment, when a length of a time section between the point in time at which the charging and discharging operation of the battery is completed and the point in time at which the voltage data of the battery is acquired is shorter than a length of the preset threshold time section, the error calculation unit 130 may predict the reference voltage based on battery data.

The error calculation unit 130 may calculate the SOC error based on a difference between the calculated SOC of the battery and the reference SOC. According to an embodiment, the error calculation unit 130 may acquire the SOC error by calculating the difference between the SOC of the battery calculated at the point in time at which the charging and discharging operation is completed and the reference SOC.

The SOH prediction unit 140 may predict a state of health (SOH) of the battery.

According to an embodiment, the SOH prediction unit 140 may calculate the SOH of the battery based on a calculated SOC and an SOC error of the battery. Here, the SOH prediction unit 140 may calculate the SOH of the battery based on the following Equation 2.

[Equation 2]

$$SOH = 100 - \frac{SOC_{error}}{SOC \text{-} SOC_{error}} * 100$$

(here, SOC may correspond to the calculated SOC of the battery, and $SOC_{error}$ may correspond to the SOC error)

According to an embodiment, the SOH prediction unit 140 may derive a linear regression equation that may predict the SOH of the battery based on the calculated SOH. The SOH prediction unit 140 may input the calculated SOH of the battery into a linear regression model to derive a linear regression equation for predicting the SOH of the battery. Here, the linear regression is a technique for modeling the linear correlation between a dependent variable and one or more independent variables, where the dependent variable may be a predicted SOH of the battery, and the independent variables may be the SOH calculated based on the SOC and the SOC error.

According to an embodiment, the SOH prediction unit 140 may collect the SOH of the battery calculated by date and derive the linear regression equation representing the SOH trend of the battery. Here, the SOH prediction unit 140 may derive the linear regression equation by considering the SOC used when calculating the SOH of the battery. The SOH prediction unit 140 may identify the SOH of the battery calculated when the SOC of the battery, that is, the calculated SOC, is equal to or greater than a threshold value, and derive the linear regression equation based on the identified SOH. For example, the SOH prediction unit 140 may derive the linear regression equation based on the SOH of the battery calculated when the SOC of the battery is 40% or more, but is not limited to this example.

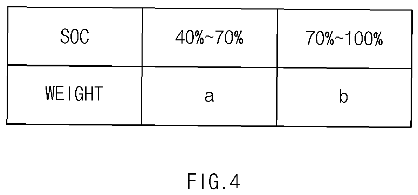

According to an embodiment, the SOH prediction unit 140 may assign a different weight to the SOH of the battery calculated based on a value of the SOC used when calculating the SOH of the battery, that is, the calculated SOC. Details related thereto will be described below in the description of FIG. 4.

The memory 150 may store the SOC of the battery, a reference OCV-SOC table, the linear regression model, the calculated SOH of the battery, and/or various commands, software, and the like, for the operation of the battery diagnostic device 100. According to an embodiment, the memory 150 may include a volatile memory device such as a static random-access memory (SRAM) or a dynamic random-access memory (DRAM), or a non-volatile memory device such as a read only memory (ROM), a programmable ROM (PROM), or a flash memory.

Referring to FIG. 1, the memory 150 is illustrated as being included in the battery prediction device 100, but is not limited thereto, and the memory 150 may be located outside the battery diagnostic device 100.

According to an embodiment, the SOC calculation unit 120, the SOH error calculation unit 130, and the SOH prediction unit 140 may be implemented as one processor or as separate processors. Here, the processor may execute software to control at least one other component (e.g., hardware or software) of the battery diagnostic device 100, or perform operations such as processing and/or calculating various data.

The battery diagnostic device 100 may transmit the predicted SOH of the battery to the outside. According to an embodiment, the battery diagnostic device 100 may provide battery information, for example, the predicted SOH of the battery by date, to a user terminal 1. In addition, the battery diagnostic device 100 may perform operations such as diagnosing abnormality of the battery based on the predicted SOH of the battery and providing an alarm through the user terminal 1. Here, the user terminal 1 may include a terminal such as a personal computer (PC) or a smartphone.

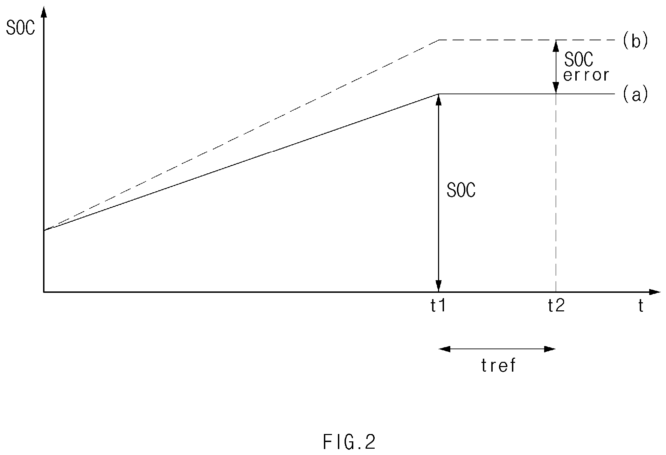

FIG. 2 is a graph for describing an SOC error according to an embodiment disclosed herein.

Referring to FIG. 2, a graph in which a horizontal axis represents time and a vertical axis represents the SOC of the battery is shown.

Among various indicators that indicate the state of a battery, a state of charge (SOC) may be an indicator that indicates a charging state of a battery, that is, a remaining capacity of the battery. The SOC of the battery is an indicator that allows a user to predict a point in time at which the battery is to be charged and a point in time at which the charging of the battery is ended, and may increase as a charging operation for the battery progresses. Here, the battery may correspond to a unit including at least one of a battery pack (not illustrated), a battery module 11, 12, 13, or 14 and/or a battery cell (not illustrated) included in each of the battery modules 11, 12, 13, and 14 described with reference to FIG. 1.

Referring to FIG. 2, as the charging operation for the battery is performed, the SOC of the battery may increase. At a point in time t1, when charging of the battery is completed, the SOC of the battery may reach its maximum value.

Referring to FIG. 2, a solid line graph a and a dotted line graph b are shown. According to an embodiment, the solid line graph a may be a graph representing the SOC of the battery calculated based on the current integration method that calculates the SOC by integrating the current of the battery. In addition, the dotted line graph b may be a graph representing a corrected SOC of the battery by taking into account various errors that may occur when calculating the SOC of the battery based on the current integration method. Here, errors that may occur when calculating a battery error may include errors due to the change in the SOH that indicate the degree of battery degradation compared to the capacity at the beginning of life of the battery, sensing errors that may occur during a process of sensing the battery current, errors due to measured voltage of the battery, and the like, but are not limited thereto. That is, when calculating the SOC of the battery according to the current integration method, a difference in capacity compared to the capacity at the beginning of life of the battery occurs as capacity degradation occurs due to the use of the battery, but since Equation 1 described with reference to FIG. 1 performs calculation based on the capacity at the beginning of life, it is difficult to reflect errors due to capacity degradation. In addition, since an error may occur depending on the accuracy of a sensing current value of the current sensor or the like, it is necessary to compensate for the error.

According to an embodiment, the SOC error disclosed herein may be a difference between the SOC of the battery calculated through the current integration method at the point in time t1 at which the charging and discharging operation for the battery is completed and the reference SOC corrected by reflecting the error due to capacity degradation of the battery for which charging is completed and the current sensing error. Here, the reference SOC may be an SOC acquired based on the reference voltage of the battery maintained in an idle state for a preset threshold time (tref) section from the point in time t1 at which the charging operation for the battery is completed, and the preset threshold time section interval may be a minimum time interval for measuring an open circuit voltage (OCV) of the battery.

FIG. 3 is a view for describing a process of calculating a reference voltage according to an embodiment disclosed herein.

As described above in the description of FIG. 2, the error calculation unit 130 (see FIG. 1) may calculate the SOC error, which is the difference between the SOC calculated by integrating the battery current at the point in time t1 at which charging of the battery is completed and the reference SOC. Here, the reference SOC may be a value obtained by converting the voltage of the battery maintained in the idle state for the preset threshold time section tref from the point in time t1 at which charging of the battery is completed into the SOC based on a reference OCV-SOC table. The reference OCV-SOC table may be a table indicating the SOC of the battery corresponding to each open circuit voltage (OCV) of the battery maintained in the idle state for the preset threshold time section tref.

The error calculation unit 130 may acquire a reference voltage for acquiring the reference SOC by comparing the time section between a point in time at which the charging and discharging operation of the battery is ended and a point in time at which voltage data of the battery is acquired with the preset threshold time section tref.

According to an embodiment, (a) when a length of the time section between the point in time t0 at which the charging and discharging operation of the battery is ended and a point in time ta at which the voltage data of the battery is acquired is longer than a length of the preset threshold time section tref, that is, when the voltage data includes a voltage value of the battery after the preset threshold time section elapses from the point in time at which the charging and discharging operation of the battery is ended, the error calculation unit 130 may acquire, as the reference voltage, the voltage of the battery at a point in time at which the preset threshold time section tref elapses from the point in time t0 at which the charging and discharging operation of the battery is ended.

According to an embodiment, (b) the length of the time section between the point in time t0 at which the charging and discharging operation of the battery is ended and a point in time tb at which the voltage data of the battery is acquired is shorter than the length of the preset threshold time section tref, the error calculation unit 130 may predict the reference voltage based on battery voltage data acquired up to the point in time tb.

According to an embodiment, the error calculation unit 130 may identify an inflection point based on the voltage data (e.g., a voltage profile) of the battery acquired up to the point in time tb. Specifically, the error calculation unit 130 may identify, as an inflection point, a point at which the sign of a value obtained when a graph related to the voltage change of the battery over time, which is included in the voltage data of the battery, is differentiated twice, is changed, but is not limited thereto.

According to an embodiment, the error calculation unit 130 may perform linear modeling of the graph related to the voltage change of the battery based on the identified inflection point. Here, the graph related to the voltage change after the charging and discharging operation of the battery is ended may be in the form of an exponential function, and the error calculation unit 130 may predict a linear graph after the inflection point by linearly modeling the exponential function. The error calculation unit 130 may predict, as the reference voltage, a voltage at a point in time at which the preset threshold time section tref elapses from the point in time t0 at which the charging and discharging operation of the battery is completed, based on the predicted graph.

The error calculation unit 130 may acquire the reference SOC corresponding to the reference voltage based on the reference OCV-SOC table.

FIG. 4 is a view for describing a weight assigned according to an embodiment disclosed herein.

The SOH prediction unit 140 (see FIG. 1) may calculate the SOH of the battery based on the SOC and the SOC error of the battery calculated based on the current integration method. According to an embodiment, the SOH prediction unit 140 may calculate the SOH of the battery based on the Equation 2 described with reference to FIG. 1.

According to an embodiment, the SOH prediction unit 140 may derive a linear regression equation that may predict the SOH of the battery based on the calculated SOH. The SOH prediction unit 140 may input the calculated SOH of the battery into a linear regression model to derive a linear regression equation for predicting the SOH of the battery.

According to an embodiment, the SOH prediction unit 140 may derive the linear regression equation by considering an SOC value used when calculating the SOH of the battery in the calculated SOH of the battery. The SOH prediction unit 140 may identify the SOH of the battery calculated when the SOC of the battery, that is, the calculated SOC, is equal to or greater than a threshold value, and derive the linear regression equation based on the identified SOH data. For example, the SOH prediction unit 140 may derive a linear regression equation based on the SOH of the battery calculated when the SOC of the battery is 40% or more, but is not limited to this example.

For example, when the SOC input into Equation 2 to calculate the SOH is 35%, the SOH may not be treated as valid data for deriving the linear regression equation. For another example, when the SOC input into Equation 2 to calculate the SOH is 65%, the SOH may be treated as valid data for deriving the linear regression equation. However, this is exemplary and the embodiment disclosed herein is not limited to the example.

According to an embodiment, the SOH prediction unit 140 may use a weighted linear regression model that derives the linear regression equation by assigning a different weight to a dependent variable based on the value of SOC input to calculate SOH. Here, the weight may increase as the value of SOC input into the weighted linear regression model increases. For example, assuming that a SOC reference of valid data for deriving the linear regression equation is 40%, the SOH prediction unit 140 may assign a weight of a to the calculated SOH of the battery when the input SOC is between 40% and 70%, and may assign a weight of b to the calculated SOH of the battery when the input SOC is between 70% and 100%, but is not limited to the examples. In this case, the value of weight b may be greater than the value of weight a. That is, when calculating the SOH of the battery, the weighted linear regression model may strengthen the influence of the calculated SOH as the input SOC value is higher.

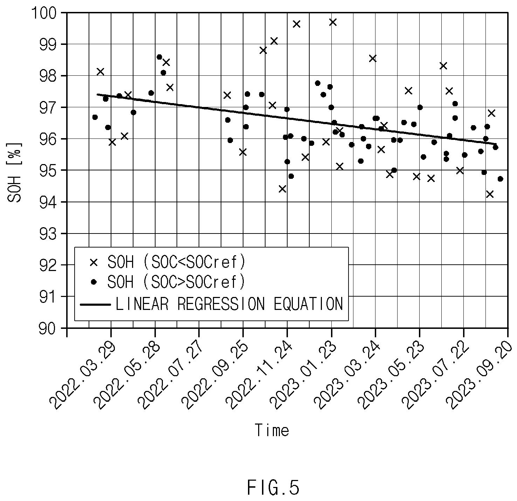

FIG. 5 is a view for describing a linear regression equation according to an embodiment disclosed herein.

Referring to FIG. 5, a calculated SOH of a battery and a linear regression equation derived based on the calculated SOH are shown.

According to an embodiment, a horizontal axis of the graph shown in FIG. 5 may represent time, and a vertical axis may represent the SOH of the battery.

Data depicted on a coordinate plane shown in FIG. 5 may represent the SOH of the battery calculated based on Equation 2 described with reference to FIG. 1. Here, data indicated by O may be the SOH calculated when the SOC input into Equation 2 is less than a threshold value SOCref, and data indicated by X may be the SOH calculated when the SOC input into Equation 2 is greater than the threshold value SOCref.

According to an embodiment, when the SOC input into Equation 2 is less than the threshold value SOCref, the calculated SOH may not be treated as valid data. That is, the SOH prediction unit 140 (see FIG. 1) may derive a linear regression equation based on the data indicated by X. The SOH prediction unit 140 may input data marked as X into a linear regression model to derive a linear regression equation representing the trend between the SOHs of batteries.

According to an embodiment, the linear regression model may be a weighted linear regression model in which a weight is assigned to increase or decrease the influence of an independent variable.

According to an embodiment, the SOH prediction unit 140 may predict the SOH of the battery by date based on the derived linear regression equation.

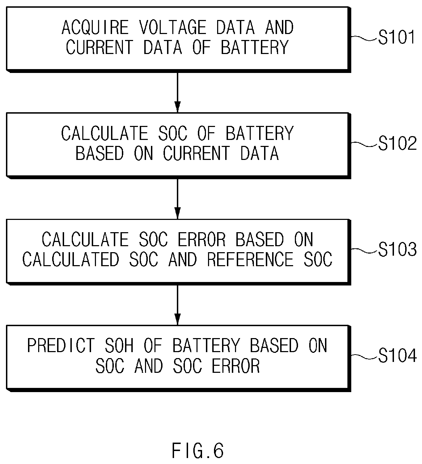

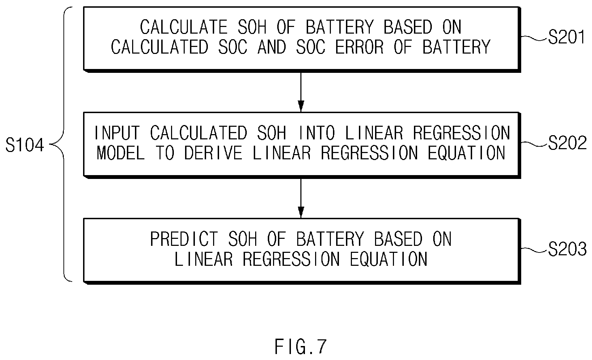

FIGS. 6 and 7 are views for describing the operation of a battery diagnostic device according to an embodiment disclosed herein.

In step S101, the battery diagnostic device 100 (see FIG. 1) may acquire voltage data and current data of a battery. Here, the battery may be a unit corresponding to any one of a battery pack, the battery module 11, 12, 13, or 14 (see FIG. 1), and at least one battery cell included in the battery module.

According to an embodiment, the voltage data and the current data may include graphs (e.g., voltage profiles and current profiles) related to changes in voltage and current of the battery over time, respectively, but are not limited thereto.

In step S102, the battery diagnostic device 100 may calculate a state of charge (SOC) of the battery based on the current data. According to an embodiment, the battery diagnostic device 100 may calculate the SOC of the battery through a current integration method based on the current data of the battery.

According to an embodiment, the current integration method may be a method of calculating the amount of charge by integrating the current during a charging/discharging cycle of the battery to an initial SOC value of the battery.

According to an embodiment, the battery diagnostic device 100 may calculate the SOC of the battery based on the Equation 1.

In step S103, the battery diagnostic device 100 may calculate an error of SOC based on the calculated SOC and a reference SOC.

According to an embodiment, the battery diagnostic device 100 may calculate the SOC error based on a difference between the calculated SOC and the reference SOC. Here, the reference SOC may be an SOC corresponding to a reference voltage, which is the voltage of the battery at a point in time at which a preset threshold time section elapses from a point in time at which the charging and discharging operation of the battery is completed.

According to an embodiment, the battery diagnostic device 100 may acquire the reference SOC corresponding to the reference voltage by converting the reference voltage based on a previously stored reference OCV-SOC table.

According to an embodiment, the battery diagnostic device 100 may acquire the reference voltage for acquiring the reference SOC by comparing a time section between a point in time at which the charging and discharging operation of the battery is ended and a point in time at which voltage data of the battery is acquired with a preset threshold time section.

According to an embodiment, when a length of the time section between the point in time at which the charging and discharging operation of the battery is ended and the point in time at which the voltage data of the battery is acquired is longer than a length of the preset threshold time section, that is, when the voltage data includes a voltage value of the battery after the preset threshold time section elapses from the point in time at which the charging and discharging operation of the battery is ended, the battery diagnostic device 100 may acquire, as the reference voltage, the voltage of the battery at a point in time at which the preset threshold time section elapses from the point in time at which the charging and discharging operation of the battery is ended.

According to an embodiment, when the length of the time section between the point in time at which the charging and discharging operation of the battery is ended and the point in time at which the voltage data of the battery is acquired is shorter than the length of the preset threshold time section, the battery diagnostic device 100 may predict the reference voltage based on the acquired battery voltage data.

According to an embodiment, the battery diagnostic device 100 may identify an inflection point based on the acquired voltage data (e.g., a voltage profile) of the battery. Specifically, the battery diagnostic device 100 may identify, as an inflection point, a point at which the sign of a value obtained when a graph related to the voltage change of the battery over time, which is included in the voltage data of the battery, is differentiated twice, is changed, but is not limited thereto.

According to an embodiment, the battery diagnostic device 100 may perform linear modeling of the graph related to the voltage change of the battery based on the identified inflection point. Here, the graph related to the voltage change after the charging and discharging operation of the battery is ended may be in the form of an exponential function, and the battery diagnostic device 100 may predict a linear graph after the inflection point by linearly modeling the exponential function. The battery diagnostic device 100 may predict, as the reference voltage, a voltage at a point in time at which the preset threshold time section elapses from the point in time at which the charging and discharging operation of the battery is completed, based on the predicted graph.

In step S104, the battery diagnostic device 100 may predict the SOH of the battery based on the SOC and the SOC error.

Referring to FIG. 7, a specific process of step S104 described with reference to FIG. 6 is illustrated.

In step S201, the battery diagnostic device 100 may calculate a state of health (SOH) of the battery based on the calculated SOC and the SOC error. According to an embodiment, the battery diagnostic device 100 may calculate the SOH of the battery based on the Equation 2.

In step S202, the battery diagnostic device 100 may input the calculated SOH into a linear regression model to derive a linear regression equation for predicting the SOH of the battery.

In step S203, the battery diagnostic device 100 may predict the SOH of the battery based on the derived linear regression equation. According to an embodiment, the battery diagnostic device 100 may predict the SOH of the battery by date based on the derived linear regression equation.

According to an embodiment, the battery diagnostic device 100 may use a weighted linear regression model that derives the linear regression equation by assigning a different weight to a dependent variable based on a value of the SOC of the battery input to calculate the SOH. Here, the weight may increase as the value of SOC input into the weighted linear regression model increases.

According to an embodiment, the linear regression model may be a weighted linear regression model in which a weight is assigned to increase or decrease the influence of an independent variable.

According to an embodiment, the battery diagnostic device 100 may predict the SOH of the battery by date based on the derived linear regression equation.

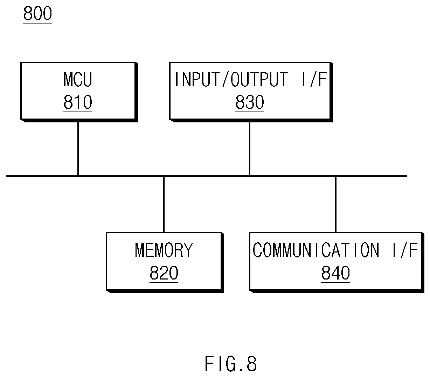

FIG. 8 is a diagram for describing a computing system according to an embodiment disclosed herein.

Referring to FIG. 8, a computing system 800 may include a microcontroller unit (MCU) 810, a memory 820, an input/output interface (I/F) 830, and a communication I/F 840.

The MCU 810 may be a processor that executes various programs (e.g., a battery SOH prediction program, or the like) stored in the memory 820, processes various data including a plurality of battery SOCs and SOHs through the programs, and causes the battery diagnostic device 100 described with reference to FIG. 1 to perform the functions.

The memory 820 may store various programs for predicting the SOH of the battery. In addition, the memory 820 may store various data generated and/or processed in the process of predicting the SOH of the target battery.

A plurality of memories 820 may be provided as needed. The memory 820 may be a volatile memory or a non-volatile memory. As the volatile memory, the memory 820 may be a random-access memory (RAM), dynamic RAM (DRAM), static RAM (SRAM), or the like. As the non-volatile memory, for the memory 820, a read-only memory (ROM), a programmable ROM (PROM), an electrically alterable ROM (EAROM), an erasable programmable ROM (EPROM), an electrically erasable programmable ROM (EEPROM,) a flash memory, or the like may be used. The examples of memories 820 listed above are only exemplary and the computing system is not limited to the examples.

The input/output I/F 830 may provide an interface that enables data to be transmitted and received by connecting an input device (not illustrated) such as a keyboard, mouse, or touch panel, and an output device (not illustrated) such as a display and the MCU 810.

The communication I/F 840 is a component capable of transmitting and receiving various data with a server, and may be any device capable of supporting wired or wireless communication. For example, a program for predicting the SOH of a battery or various data may be transmitted to and received from a separately provided external server through the communication I/F 840.

In this way, the method of predicting the SOH of a battery according to an embodiment disclosed herein may be recorded in the memory 820 and executed by the MCU 810.

In the above, all components constituting the embodiments have been described as being combined as one or operating in combination, but are not necessarily limited to such embodiments, and within the scope of the purpose, all components may be selectively combined as one or more and operated. In addition, terms such as "include," "comprise," or "have" described above mean that the corresponding component can be present unless otherwise stated, and thus it should be construed that other components may be further included rather than excluding other components.

The above description is merely an example of the technical idea disclosed herein, and those with ordinary skill in the art to which the embodiments disclosed herein belong may make various modifications and variations without departing from the essential characteristics of the embodiments disclosed herein.

Accordingly, the embodiments disclosed herein are not intended to limit the technical ideas disclosed herein but rather to explain them, and the scope of the technical ideas disclosed herein is not limited by these embodiments. The scope of protection disclosed herein should be interpreted by the accompanying claims, and all technical ideas within the scope equivalent thereto should be construed as being included in the scope of rights herein.

(Reference Signs List)

| 1: | User terminal | 10: | Target device |
|---|---|---|---|
| 11, 12, 13, 14: | Battery module | 100: | Battery diagnostic device |
| 110: | Data acquisition unit | 120: | SOC calculation unit |
| 130: | Error calculation unit | 140: | SOH prediction unit |

(continued)

| 150: | Memory |
|------|--------|

**Claims**

1. A battery diagnostic device comprising:

   a data acquisition unit configured to acquire voltage data and current data of a battery;
   a state of charge (SOC) calculation unit configured to calculate an SOC of the battery based on the current data;
   an error calculation unit configured to calculate an SOC error of the battery based on the calculated SOC of the battery and a reference SOC of the battery; and
   a state of health (SOH) prediction unit configured to calculate an SOH of the battery based on the SOC and the SOC error of the battery, input the calculated SOH of the battery into a linear regression model to derive a linear regression equation of the SOH of the battery, and predict the SOH of the battery based on the linear regression equation.

2. The battery diagnostic device of claim 1, wherein the SOC calculation unit calculates the SOC of the battery based on a current integration method that integrates the current data, and the current integration method is performed based on the following Equation 1.

$$[\text{Equation 1}]$$

$$SOC = \frac{\int i\, dt}{Capacity_{BoL}}$$

(the $Capacity_{BoL}$ corresponds to an initial capacity of the battery)

3. The battery diagnostic device of claim 1, wherein the error calculation unit calculates the SOC error by calculating a difference between the SOC of the battery and a reference SOC that is an SOC obtained by converting a reference voltage based on a reference OCV-SOC table.

4. The battery diagnostic device of claim 3, wherein the reference voltage includes data related to a voltage of a battery maintained in an idle state for a preset threshold time section from a point in time at which a charging and discharging operation of the battery is ended.

5. The battery diagnostic device of claim 4, wherein the error calculation unit predicts the reference voltage based on the voltage data when a length of a time section between the point in time at which the charging and discharging operation of the battery is ended and a point in time at which the voltage data is acquired is shorter than a length of the threshold time section.

6. The battery diagnostic device of claim 5, wherein the error calculation unit identifies an inflection point of a voltage graph over time, from the point in time at which the charging and discharging operation of the battery is ended, that is included in the voltage data, and performs exponential function linear modeling based on the identified inflection point to generate a voltage graph up to the length of the threshold time section.

7. The battery diagnostic device of claim 6, wherein the error calculation unit predicts a voltage after the threshold time section elapses from the point in time at which the charging and discharging operation is ended as the reference voltage based on the generated voltage graph.

8. The battery diagnostic device of claim 1, wherein the SOH prediction unit calculates the SOH of the battery based on the following Equation 2.

[Equation 2]

$$SOH = 100 - \frac{SOC_{error}}{SOC - SOC_{error}} * 100$$

(here, $SOC_{error}$ corresponds to the SOC error)

9. The battery diagnostic device of claim 8, wherein the linear regression model includes a weighted linear regression model that assigns a different weight to an independent variable, and
the independent variable corresponds to the calculated SOH of the battery.

10. The battery diagnostic device of claim 9, wherein the SOH prediction unit derives the linear regression equation by assigning a different weight to the calculated SOH based on the SOC value, wherein a value of the weight increases as the SOC value increases.

11. A method of operating a battery diagnostic device, comprising:

acquiring voltage data and current data of a battery;
calculating an SOC of the battery based on the current data;
calculating an SOC error of the battery based on the calculated SOC of the battery and a reference SOC of the battery; and
calculating an SOH of the battery based on the SOC and the SOC error of the battery, inputting the calculated SOH of the battery into a linear regression model to derive a linear regression equation of the SOH of the battery, and predicting the SOH of the battery based on the linear regression equation.

12. The method of claim 11, wherein the calculating of the SOC of the battery includes calculating the SOC of the battery based on a current integration method that integrates the current data, and the current integration method is performed based on the following Equation 1.

[Equation 1]

$$SOC = \frac{\int i\, dt}{Capacity_{BoL}}$$

(the $Capacity_{BoL}$ corresponds to an initial capacity of the battery)

13. The method of claim 11, wherein the calculating of the SOC error includes:

acquiring a reference SOC corresponding to a reference voltage based on a reference OCV-SOC table; and
calculating a difference between the calculated SOC and the reference SOC.

14. The method of claim 13, wherein the reference voltage includes data related to a voltage of a battery maintained in an idle state for a preset threshold time section from a point in time at which a charging and discharging operation of the battery is ended.

15. The method of claim 13, wherein the acquiring of the reference SOC corresponding to the reference voltage includes:

identifying a length of a time section between a point in time at which the charging and discharging operation of the battery is ended and a point in time at which the voltage data is acquired;
identifying an inflection point of a voltage graph over time, from a point in time at which the charging and discharging operation of the battery is ended, that is included in the voltage data when the length of the time section is shorter than a length of a preset threshold time section; and
performing exponential function linear modeling based on the identified inflection point to generate a voltage graph up to the length of the threshold time section.

16. The method of claim 11, wherein the predicting of the SOH of the battery is performed based on the following Equation 2.

[Equation 2]

$$SOH = 100 - \frac{SOC_{error}}{SOC - SOC_{error}} * 100$$

(here, $SOC_{error}$ corresponds to the SOC error, SOC corresponds to an SOC calculated based on the current data, and $Capacity_{BoL}$ corresponds to an initial capacity of the battery)

17. The method of claim 16, wherein the linear regression model includes a weighted linear regression model that assigns a different weight to an independent variable, and
the independent variable corresponds to the calculated SOH of the battery.

```
┌─────────────────────────────────┐      ┌───────────────────────────────────────────────┐
│        TARGET DEVICE            │      │          BATTERY DIAGNOSTIC DEVICE            │
│            10                   │      │                   100                         │
│  ┌───────────────────────────┐  │      │  ┌─────────────────────┐ ┌──────────────────┐ │
│  │     BATTERY MODULE        │  │      │  │  DATA ACQUISITION   │ │ SOC CALCULATION  │ │
│  │          11               │  │      │  │       UNIT          │ │      UNIT        │ │
│  └───────────────────────────┘  │      │  │       110           │ │      120         │ │
│  ┌───────────────────────────┐  │      │  └─────────────────────┘ └──────────────────┘ │
│  │     BATTERY MODULE        │  │ ⟺    │  ┌─────────────────────┐ ┌──────────────────┐ │
│  │          12               │  │      │  │ ERROR CALCULATION   │ │  SOH PREDICTION  │ │
│  └───────────────────────────┘  │      │  │       UNIT          │ │      UNIT        │ │
│  ┌───────────────────────────┐  │      │  │       130           │ │      140         │ │
│  │     BATTERY MODULE        │  │      │  └─────────────────────┘ └──────────────────┘ │
│  │          13               │  │      │  ┌─────────────────────┐                       │
│  └───────────────────────────┘  │      │  │      MEMORY         │                       │
│  ┌───────────────────────────┐  │      │  │       150           │                       │
│  │     BATTERY MODULE        │  │      │  └─────────────────────┘                       │
│  │          14               │  │      │                                               │
│  └───────────────────────────┘  │      └───────────────────────────────────────────────┘
└─────────────────────────────────┘                           ⇕
                                           ┌──────────────────────────┐
                                           │      USER TERMINAL       │
                                           │            1             │
                                           └──────────────────────────┘
```

FIG.1

FIG.2

EP 4 764 543 A1

(a)

END CHARGING AND
DISCHARGING OPERATION
t0

tref

ACQUIRE
VOLTAGE DATA
ta

(b)

END CHARGING AND
DISCHARGING OPERATION
t0

ACQUIRE
VOLTAGE DATA
tb

tref

FIG.3

| SOC | 40%~70% | 70%~100% |
|--------|---------|----------|
| WEIGHT | a | b |

FIG.4

FIG.5

ACQUIRE VOLTAGE DATA AND
CURRENT DATA OF BATTERY ——S101

CALCULATE SOC OF BATTERY
BASED ON CURRENT DATA ——S102

CALCULATE SOC ERROR BASED ON
CALCULATED SOC AND REFERENCE SOC ——S103

PREDICT SOH OF BATTERY BASED ON
SOC AND SOC ERROR ——S104

FIG.6

```
        ┌─────────────────────────────────────────────┐
        │  CALCULATE SOH OF BATTERY BASED ON          │──S201
        │  CALCULATED SOC AND SOC ERROR OF BATTERY    │
        └─────────────────────────────────────────────┘
                             │
                             ▼
S104 ┤  ┌─────────────────────────────────────────────┐
        │ INPUT CALCULATED SOH INTO LINEAR REGRESSION │──S202
        │ MODEL TO DERIVE LINEAR REGRESSION EQUATION  │
        └─────────────────────────────────────────────┘
                             │
                             ▼
        ┌─────────────────────────────────────────────┐
        │     PREDICT SOH OF BATTERY BASED ON         │──S203
        │       LINEAR REGRESSION EQUATION            │
        └─────────────────────────────────────────────┘
```

FIG.7

800

```
┌─────────────┐   ┌──────────────────┐
│ MCU         │   │ INPUT/OUTPUT I/F │
│ 810         │   │ 830              │
└──────┬──────┘   └────────┬─────────┘
       │                   │
───────┼───────┬───────────┼─────────────
       │       │           │
     ┌─┴────┐ ┌┴──────────┐
     │MEMORY│ │COMMUNICATION I/F│
     │ 820  │ │ 840       │
     └──────┘ └───────────┘
```

FIG.8

# EP 4 764 543 A1

<table>
<tr><td colspan="2" align="center">**INTERNATIONAL SEARCH REPORT**</td><td colspan="2">International application No.<br><br>**PCT/KR2025/000860**</td></tr>
</table>

**A.    CLASSIFICATION OF SUBJECT MATTER**

**G01R 31/392**(2019.01)i; **G01R 31/367**(2019.01)i; **G01R 31/382**(2019.01)i; **G01R 31/36**(2006.01)i; **G01R 31/396**(2019.01)i; **G06F 17/18**(2006.01)i

According to International Patent Classification (IPC) or to both national classification and IPC

**B.    FIELDS SEARCHED**

Minimum documentation searched (classification system followed by classification symbols)

G01R 31/392(2019.01); B60L 11/18(2006.01); G01N 27/416(2006.01); G01R 19/165(2006.01); G01R 31/36(2006.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 전압(voltage), 전류(current), SOC, 오차(error), SOH

**C.    DOCUMENTS CONSIDERED TO BE RELEVANT**

| Category* | Citation of document, with indication, where appropriate, of the relevant passages | Relevant to claim No. |
|---|---|---|
| Y | US 2012-0296586 A1 (KIRCHEV, Angel Zhivkov) 22 November 2012 (2012-11-22)<br>      See paragraphs [0019]-[0044], claim 1 and figures 1-7. | 1-2,11-12 |
| A |  | 3-10,13-17 |
| Y | JP 2023-018289 A (HONDA MOTOR CO., LTD.) 08 February 2023 (2023-02-08)<br>      See claims 1-2. | 1-2,11-12 |
| A | KR 10-2010-0019249 A (LG CHEM, LTD.) 18 February 2010 (2010-02-18)<br>      See paragraphs [0063]-[0066] and figures 6-7. | 1-17 |
| A | KR 10-2012-0114584 A (SB LIMOTIVE CO., LTD.) 17 October 2012 (2012-10-17)<br>      See claim 1. | 1-17 |
| A | KR 10-1399362 B1 (SK C&C CO., LTD.) 30 May 2014 (2014-05-30)<br>      See paragraphs [0034]-[0075] and figures 1-9. | 1-17 |

☐ Further documents are listed in the continuation of Box C.          ☑ See patent family annex.

| | |
|---|---|
| \*       Special categories of cited documents:<br>"A"   document defining the general state of the art which is not considered to be of particular relevance<br>"D"   document cited by the applicant in the international application<br>"E"   earlier application or patent but published on or after the international filing date<br>"L"   document which may throw doubts on priority claim(s) or which is cited to establish the publication date of another citation or other special reason (as specified)<br>"O"   document referring to an oral disclosure, use, exhibition or other means<br>"P"   document published prior to the international filing date but later than the priority date claimed | "T"   later document published after the international filing date or priority date and not in conflict with the application but cited to understand the principle or theory underlying the invention<br>"X"   document of particular relevance; the claimed invention cannot be considered novel or cannot be considered to involve an inventive step when the document is taken alone<br>"Y"   document of particular relevance; the claimed invention cannot be considered to involve an inventive step when the document is combined with one or more other such documents, such combination being obvious to a person skilled in the art<br>"&"   document member of the same patent family |

| Date of the actual completion of the international search | Date of mailing of the international search report |
|---|---|
| **18 April 2025** | **18 April 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2025/000860**

| Patent document cited in search report | | | Publication date (day/month/year) | Patent family member(s) | | | Publication date (day/month/year) |
|---|---|---|---|---|---|---|---|
| US | 2012-0296586 | A1 | 22 November 2012 | AU | 2011-209525 | A1 | 16 August 2012 |
| | | | | BR | 112012018548 | A2 | 03 May 2016 |
| | | | | EP | 2529242 | A1 | 05 December 2012 |
| | | | | EP | 2529242 | B1 | 14 April 2021 |
| | | | | FR | 2955670 | A1 | 29 July 2011 |
| | | | | FR | 2955670 | B1 | 27 January 2012 |
| | | | | JP | 2013-518272 | A | 20 May 2013 |
| | | | | MA | 34001 | B1 | 01 February 2013 |
| | | | | US | 8589097 | B2 | 19 November 2013 |
| | | | | WO | 2011-092403 | A1 | 04 August 2011 |
| | | | | ZA | 201205219 | B | 27 March 2013 |
| JP | 2023-018289 | A | 08 February 2023 | CN | 115684947 | A | 03 February 2023 |
| | | | | JP | 7299274 | B2 | 27 June 2023 |
| | | | | US | 2023-0029810 | A1 | 02 February 2023 |
| KR | 10-2010-0019249 | A | 18 February 2010 | BR | PI0912066 | A2 | 05 January 2016 |
| | | | | BR | PI0912066 | B1 | 08 October 2019 |
| | | | | CN | 102119338 | A | 06 July 2011 |
| | | | | CN | 102119338 | B | 21 August 2013 |
| | | | | EP | 2321663 | A1 | 18 May 2011 |
| | | | | EP | 2321663 | B1 | 27 May 2015 |
| | | | | JP | 2011-530696 | A | 22 December 2011 |
| | | | | JP | 5269994 | B2 | 21 August 2013 |
| | | | | TW | 201007190 | A | 16 February 2010 |
| | | | | TW | I381182 | B | 01 January 2013 |
| | | | | US | 2010-0036626 | A1 | 11 February 2010 |
| | | | | US | 2012-0035873 | A1 | 09 February 2012 |
| | | | | US | 8046181 | B2 | 25 October 2011 |
| | | | | US | 8332169 | B2 | 11 December 2012 |
| | | | | WO | 2010-016647 | A1 | 11 February 2010 |
| KR | 10-2012-0114584 | A | 17 October 2012 | KR | 10-1223735 | B1 | 21 January 2013 |
| | | | | US | 2012-0256599 | A1 | 11 October 2012 |
| | | | | US | 9170305 | B2 | 27 October 2015 |
| KR | 10-1399362 | B1 | 30 May 2014 | | None | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240021602